# EUROPÄISCHE PATENTSCHRIFT

(11) **EP 1 880 587 B1**
(45) Veröffentlichungstag und Bekanntmachung des Hinweises auf die Patenterteilung: **13.08.2008**
(21) Anmeldenummer: 06742333.5
(22) Anmeldetag: 12.05.2006
(51) Int. Cl.: H05K 1/02

(54) **LEITERPLATTE**
PRINTED CIRCUIT BOARD
CARTE DE CIRCUITS IMPRIMES

(30) Priorität: 12.05.2005 DE 102005022062
(43) Veröffentlichungstag der Anmeldung: 23.01.2008
(73) Patentinhaber: Conti Temic microelectronic GmbH, 90411 Nürnberg (DE)
(72) Erfinder: FRIEDRICH, Ferdinand, 90562 Heroldsberg (DE); TRAGESER, Hubert, 91338 Igensdorf (DE); SCHUCH, Bernhard, 91616 Neusitz (DE); NEHMEIER, Friedrich, 91085 Weisendorf (DE)
(74) Vertreter: Büchner, Jörg
(86) Internationale Anmeldenummer: PCT/DE2006/000825
(87) Internationale Veröffentlichungsnummer: WO 2006/119756

(56) Entgegenhaltungen:
- DE-A1- 10 335 805
- GB-A- 2 325 082
- US-A1- 2003 184 970
- US-A1- 2004 119 157

## Beschreibung

Die Erfindung betrifft eine Leiterplatte nach dem Oberbegriff des Anspruches 1.

Eine derartige Leiterplatte ist durch offenkundige Vorbenutzung bekannt. Derartige Leiterplatten werden zur SMD-Bestückung mit elektronischen Bauelementen eingesetzt. Bei den elektronischen Bauelementen kann es sich um solche handeln, die im Betrieb eine erhebliche Abwärme erzeugen. Diese Abwärme muss, um eine Zerstörung der elektronischen Bauteile zu verhindern, effizient abgeführt werden. Bei dieser Wärmeabfuhr stellt die Leiterplatte in aller Regel das Element mit dem höchsten thermischen Widerstand bzw. Wärme(übergangs)widerstand dar. Der thermische Widerstand der vorbekannten Leiterplatte ist für anspruchsvolle Bestückungsaufgaben noch zu hoch.

Es ist daher eine Aufgabe der vorliegenden Erfindung, eine Leiterplatte der eingangs Art derart weiterzubilden, dass der thermische Widerstand der Leiterplatte zwischen dem elektronischen Bauteil und der wärmeabführenden Unterlage verringert wird.

Diese Aufgabe ist erfindungsgemäß gelöst durch eine Leiterplatte mit den im Kennzeichnungsteil des Anspruches 1 angegebenen Merkmalen.

An den freien Flächenabschnitten wird das elektronische Bauelement mit der Leiterplatte verbunden. Da diese freien Flächenabschnitte zur Vergrößerung der Verbindungsfläche frei sind von Wärmedurchgangsöffnungen, liegt dort ein erschwerter Wärmeübergang vor. Erfindungsgemäß wurde erkannt, dass das Konzept der von Wärmedurchgangsöffnungen freien Flächenabschnitte beibehalten werden kann, wenn die freien Flächenabschnitte zumindest längsseitig von Wärmedurchgangsöffnungen umgeben sind. Diese Wärmedurchgangsöffnungen verringern den thermischen Widerstand der Leiterplatte. Durch die erfindungsgemäße Anordnung ist gewährleistet, dass in unmittelbarer Nachbarschaft der freien Flächenabschnitte eine ausreichende Anzahl von Wärmedurchgangsöffnungen vorliegt, die einen Wärmedurchtritt ermöglichen, sodass der thermische Widerstand der Leiterplatte insgesamt auch im Bereich der freien Flächenabschnitte ausreichend gering und damit unkritisch ist. Jeder Längsseite der freien Flächenabschnitte sind Wärmedurchgangsöffnungen zugeordnet.

Zur ausreichenden Anbindung des elektronischen Bauteils an die Leiterplatte muss eine gewisse Mindest-Verbindungsfläche auf der Oberseite der Leiterplatte bereitgestellt werden. Wie erkannt wurde, kann diese Mindest-Verbindungsfläche auf eine Mehrzahl freier Flächenabschnitte verteilt werden. Je geringer die Fläche der einzelnen freien Flächenabschnitte ist, desto geringer ist die Gefahr, dass hier ein gefährlicher Wärmestau auftritt. Daher ist die Ausgestaltung nach Anspruch 2 vorteilhaft.

Eine Anordnung nach Anspruch 3 erhöht die Wärmeabfuhr im den freien Flächenabschnitten benachbarten Bereich.

Dies gilt insbesondere für die Anordnung nach Anspruch 4.

Eine Packungsdichte von Wärmedurchgangsöffnungen nach Anspruch 5 führt zu einem auch für anspruchsvolle Bestückungsaufgaben ausreichend geringen thermischen Widerstand der Leiterplatte.

Die Wärmedurchgangsöffnungen sind dort zum Wärmedurchgang am effizientesten, wo sie vom elektronischen Bauteil abgedeckt werden. Daher führt die Anordnung nach Anspruch 6 bei gegebener Anzahl von Wärmedurchgangsöffnungen zu einem vorteilhaft geringen thermischen Widerstand.

Eine Anpassung nach Anspruch 7 führt zu einer effizienten, insbesondere kompakten Wärmedurchgangsanordnung.

Rastermaße nach Anspruch 8 haben sich zur Schaffung eines geringen thermischen Widerstandes als besonders vorteilhaft herausgestellt.

Eine Packung nach Anspruch 9 erlaubt die Unterbringung einer hohen Anzahl von Wärmedurchgangsöffnungen bei gegebenem Rastermaß und gegebener Fläche. Der thermische Widerstand kann hierdurch im Vergleich zu weniger dichten Packungen nochmals verringert werden.

Eine Lotschicht nach Anspruch 10 verhindert, dass beim Auflöten des elektronischen Bauteils Lot in die Wärmedurchgangsöffnungen eindringt. Der vorteilhaft niedrige thermische Widerstand der Wärmedurchgangsöffnungen bleibt dann erhalten. Eine Begrenzung der flächenmäßigen Ausdehnung der Lotschicht derart, dass sie nur innerhalb der freien Flächenabschnitte vorliegt, erfolgt bevorzugt durch den Einsatz eines die Lotschicht und gegebenenfalls einzelne Abschnitte hiervon umgebende Schicht aus Lötstoplack. Durch die Begrenzung der Lotschicht auf die freien Flächenabschnitte wird ein definiertes Lötergebnis erzielt. Kurzschlüsse auf der Unterseite der Leiterplatte, z. B. zu einem Kühlkörper hin, werden vermieden. Soweit Lötstoplack eingesetzt wird, sind bevorzugt die freien Flächenabschnitte frei von Lötstoplack, sodass dort Lot aufgebracht werden kann.

Lotschichtabmessungen nach Anspruch 11 stellen einen guten Kompromiss dar zwischen ausreichender Größe der Verbindungsfläche zur sicheren Verbindung des elektronischen Bauteils mit der Leiterplatte einerseits und geringstmöglicher Fläche zur Reduzierung des thermischen Widerstands andererseits. Die Begrenzung der Größe der freien Flächenabschnitte führt zudem dazu, dass beim Löten Lunker in der Lotschicht vermieden werden.

Wärmedurchgangsöffnungen nach Anspruch 12 lassen sich besonders dicht packen.

Wärmedurchgangsöffnungen nach Anspruch 13 weisen einen vorteilhaft niedrigen thermischen Widerstand auf.

Wärmedurchgangsöffnungen nach Anspruch 14 lassen sich kostengünstig herstellen.

Ausführungsbeispiele der Erfindung werden nachfolgend anhand der Zeichnung näher erläutert. In dieser zeigen:
- Fig. 1: schematisch und perspektivisch ein elektronisches Bauteil, welches über eine Leiterplatte an einem Kühlkörper montiert ist;
- Fig. 2: vergrößert perspektivisch die Leiterplatte beim Aufbau nach Fig. 1;
- Fig. 3: gegenüber Fig. 2 verkleinert und gegenüber Fig. 1 vergrößert die auf dem Kühlkörper aufgebrachte Leiterplatte;
- Fig. 4: etwa im Maßstab von Fig. 2 eine Aufsicht auf die Leiterplatte, die die Anordnung von Wärmedurchgangsöffnungen in der Leiterplatte deutlich macht;
- Fig. 5: einen vergrößerten und gebrochen dargestellten Vertikalschnitt durch den Aufbau nach Fig. 1;
- Fig. 6: eine zu Fig. 4 ähnliche Aufsicht einer weiteren Ausführungsform einer Leiterplatte;
- Fig. 7 bis 20 zu Fig. 4: ähnliche Aufsichten weiterer Ausführungsformen von Leiterplatten; und
- Fig. 21: ein Diagramm, welches in Abhängigkeit von der Anzahl der Wärmedurchgangsöffnungen den thermischen Widerstand verschiedener Ausführungsformen der Leiterplatten zeigt.

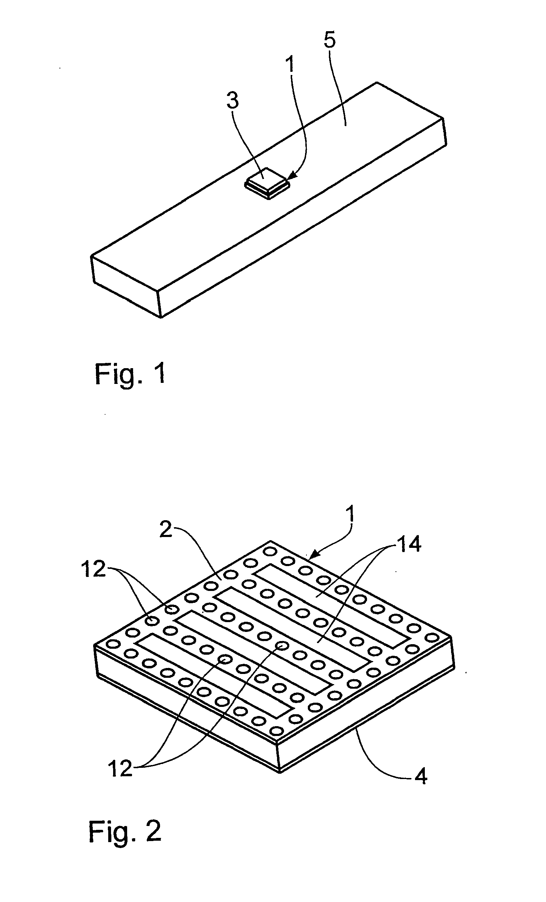

Fig. 1 zeigt schematisch einen beispielhaften Aufbau, bei dem eine Leiterplatte 1, ein sogenanntes Pad, zum Einsatz kommt. Dieser schematische Aufbau hat in der Regel mit dem tatsächlichen Einsatzumfeld der Leiterplatte 1 nichts gemein und wird zur Bestimmung des thermischen Widerstandes Rₜₕ durch die Leiterplatte 1 herangezogen. Tatsächlich stellt die Leiterplatte 1 in der Form, wie sie in der Zeichnung dargestellt und nachfolgend beschrieben ist, lediglich einen Ausschnitt einer realen Leiterplatte mit einer Mehrzahl elektronischer Bauteile und zugehöriger Leiterbahnen dar. Wenn in dieser Beschreibung daher von einer Leiterplatte 1 die Rede ist, ist tatsächlich ein Ausschnitt einer realen Leiterplatte gemeint. Auf einer Oberseite 2 der Leiterplatte 1 liegt ein elektronisches Bauteil 3. Hierbei handelt es sich z. B. um einen Feldeffekttransistor FET zum Einsatz insbesondere im Bereich Automotive, z. B. bei Zündsystemen. Aufgrund der Auflage auf der Leiterplatte 1 wird das elektronische Bauteil 3 in SMD-(Surface-Mounted-Device)Bauweise montiert. Eine Unterseite 4 der Leiterplatte 1 liegt auf einer wärmeabführenden Unterlage, einem Kupferblock 5, auf. Anstelle eine Kupferblockes 5 kann auch ein Aluminiumblock eingesetzt sein. Generell kann bei einer Variante der dargestellten Ausführungen anstelle von Kupfer Aluminium eingesetzt sein.

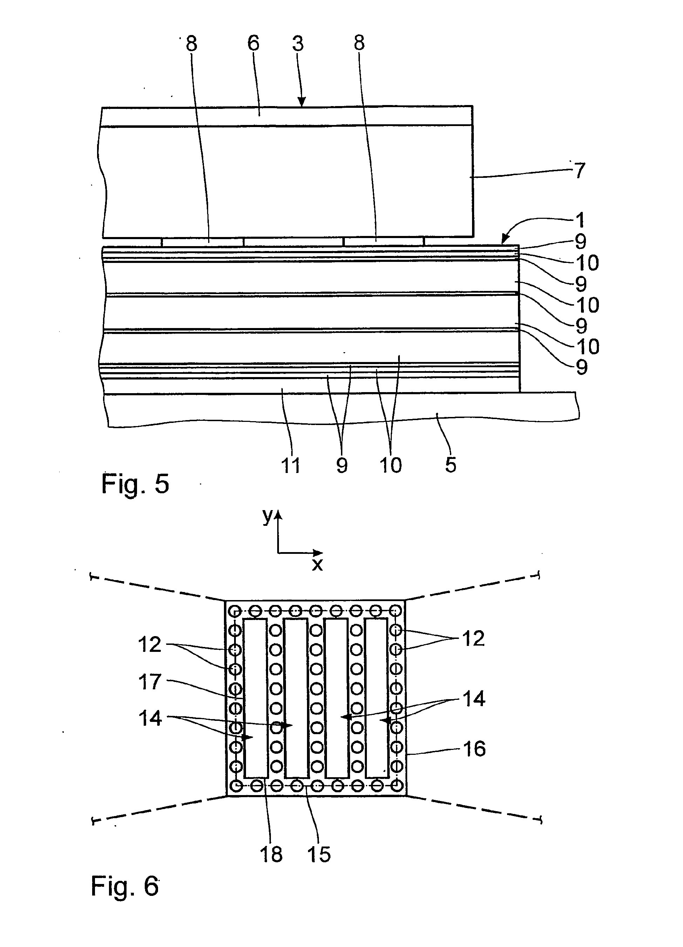

Der Vertikalschnitt nach Fig. 5 durch den Aufbau nach Fig. 1 verdeutlicht die unterschiedlichen Schichten, aus denen die Leiterplatte 1 und das elektronische Bauteil 3 aufgebaut sind, und zeigt zudem die Verbindungsschichten zwischen den Komponenten des Aufbaus nach Fig. 1. Die in Fig. 5 oberste Schicht ist eine Siliziumschicht 6, die das eigentliche elektronische Bauteil darstellt. Diese Siliziumschicht 6 ist mit einer darunterliegenden Kupferlage 7, dem so genannten Spreader, zur Wärmeabfuhr verbunden. Die Kupferlage 7 ist über eine abschnittsweise Lotschicht 8 mit der Leiterplatte 1 verbunden. Zwischen den einzelnen Abschnitten der Lotschicht 8 kann auf die Leiterplatte 1 ein Lötstoplack aufgetragen sein. Der Lötstoplack stellt eine definierte Ausdehnung der einzelnen Abschnitte der Lotschicht 8 sicher, wobei idealerweise jeder Einzelabschnitt der Lotschicht 8 vollständig von Lötstoplack umgeben ist, der auf diese Weise eine Begrenzung der Lotschicht 8 in allen Richtungen parallel zur Ebene der Leiterplatte 1 darstellt. Die Leiterplatte 1 wiederum stellt einen Schichtaufbau dar aus einer Mehrzahl von Kupferschichten 9 und Prepregschichten 10. Zwei der Kupferschicht 9 begrenzen die Leiterplatte 1 oben und unten, sodass sowohl längs der Oberseite als auch längs der Unterseite eine gute oberflächliche Wärmeleitung über die gesamte Fläche der Leiterplatte 1 vorliegt. Über eine weitere Lotschicht 11 ist die Leiterplatte 1 auf den Kupferblock 5 aufgelötet. An Stelle der in Fig. 5 unteren Lotschicht 11 kann auch ein Wärmeleitkleber eingesetzt werden. Ein derartiger Wärmeleitkleber kann zusätzlich die Funktion eines elektrischen Isolators erfüllen.

Die Leiterplatte 1 weist eine Mehrzahl von Wärmdurchgangsöffnungen 12 auf, die einen Wärmedurchgang von der Oberseite 2 zur Unterseite 4, also bei montierter Leiterplatte 1 zwischen dem elektronischen Bauteil 3 und dem Kupferblock 5, schaffen. Bei der Ausführung nach Fig. 2 liegen die Wärmedurchgangsöffnungen 12 frei, also ungefüllt, vor. Jede Wärmedurchgangsöffnung 12 trägt innenseitig eine nicht im einzelnen dargestellte wärmeleitende Beschichtung. Hierbei handelt es sich um eine Kupferbeschichtung mit einer Schichtdicke von 30 bis 35 µm. Die Wärmedurchgangsöffnungen 12 sind als senkrecht zu einer Hauptebene 13 (vgl. Fig. 5) der Leiterplatte 1 verlaufende Durchgangsbohrungen ausgeführt. Die Wärmedurchgangsöffnungen 12 haben bei der Ausführung nach Fig. 2 eine Weite von 0,3 mm.

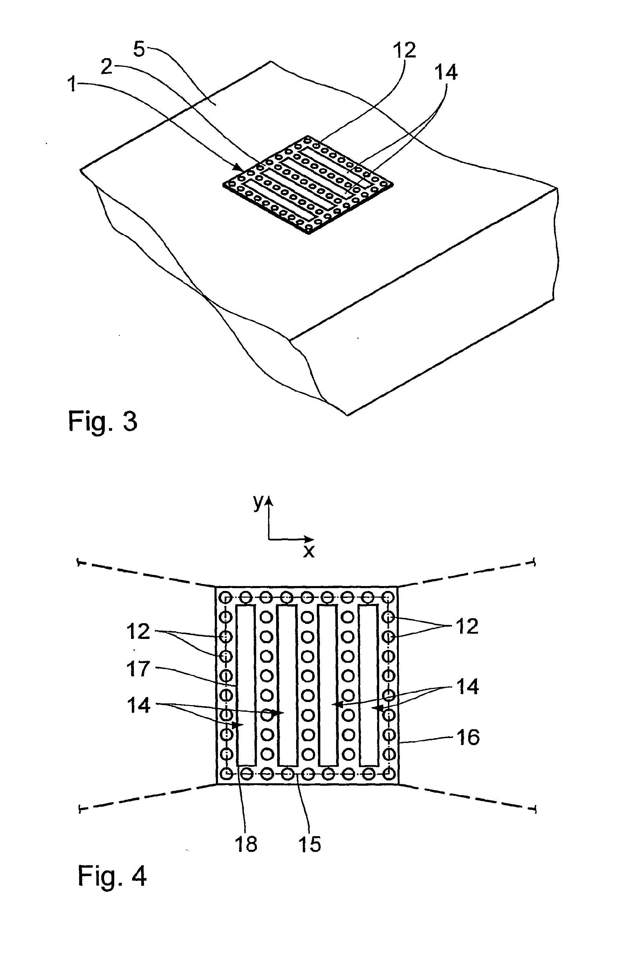

Die Leiterplatte 1 ist rechteckig mit Außenabmessungen von 9 mm (in der x-Richtung, also in der in Fig. 4 horizontalen Erstreckungsrichtung) mal 10 mm (in der y-Richtung, also in der in Fig. 4 vertikalen Erstreckungsrichtung).

Ingesamt liegt bei der Ausführung nach Fig. 2 eine Anzahl von 58 Wärmedurchgangsöffnungen 12 vor. Diese sind auf der Oberseite 2 der Leiterplatte 1 derart ungleich verteilt, dass die Oberseite 2 mehrere freie Flächenabschnitte 14, bei der Ausführung nach Fig. 2 insgesamt vier freie Flächenabschnitte 14, aufweist. Diese freien Flächenabschnitte 14 sind zur Verbindung des elektronischen Bauteils 3 mit der Leiterplatte 1 frei von Wärmedurchgangsöffnungen 12, sodass im Bereich der freien Flächenabschnitte 14 keine Wärmedurchgangsöffnungen 12 vorliegen. Die Lotschicht 8 kann aufgrund des Lötstoplacks nur im Bereich der freien Flächenabschnitte 14 auf der Oberseite 2 zur Verbindung mit dem elektronischen Bauteil 3 aufgebracht werden. Die freien Flächenabschnitte 14 sind bei der Ausführung nach Fig. 4 als vier Spalten parallel zur längeren Seite der rechteckigen Leiterplatte 1 (y-Richtung) angeordnet. Die freien Flächenabschnitte 14 liegen innerhalb eines rechteckigen Verbindungsbereiches 15, in dem bei montiertem elektronischen Bauteil 3 dieses an der Oberseite 2 der Leiterplatte 1 anliegt. Die vier freien Flächenabschnitte 14 sind rechteckig mit Abmessungen von 0,9 mm in x-Richtung und 8 mm in y-Richtung. Die Wärmedurchgangsöffnungen 12 sind auf der Leiterplatte 1 derart angeordnet, dass sie bei aufgelegtem elektronischen Bauteil 3 von diesem zumindest teilweise abgedeckt bzw. geometrisch überdeckt werden.

Die Seitenabmessungen der Leiterplatte 1 bzw. des Pads sind derart, dass ein Flächenbereich 16 der Oberseite 2 der Leiterplatte 1, der mit Wärmedurchgangsöffnungen 12 versehen ist, geometrisch an die Geometrie des Verbindungsbereichs 15 des elektronischen Bauteils 3, der an der Oberseite 2 der Leiterplatte 1 anliegt, angepasst ist.

Der rechteckige Verbindungsbereich 15 hat die Abmessungen 8 mm x 9 mm, wobei die Anpassung des mit Wärmedurchgangsöffnungen 12 versehenen Flächenbereichs 16 an die Abmessungen des Verbindungsbereichs 15 derart ist, dass der Flächenbereich 16 über alle vier Seiten des Verbindungsbereichs 15 jeweils um 0,5 mm übersteht.

Abgesehen von den freien Flächenabschnitten 14 sind bei der Ausführung nach Fig. 2 die Wärmedurchgangsöffnungen 12 in einem regelmäßigen Raster ohne Versatz mit einer Rasterweite von 1,0 mm angeordnet.

Benachbart zu in y-Richtung verlaufenden Längsseiten 17 der freien Flächenabschnitte 14 sind jeweils acht Wärmedurchgangsöffnungen 12 angeordnet. Benachbart zu in x-Richtung verlaufenden Schmalseiten 18 der freien Flächenabschnitte 14 ist nochmals jeweils eine Wärmedurchgangsöffnung 12 angeordnet. Zudem ist benachbart zu jeder Ecke der freien Flächenabschnitte 14 noch eine Wärmedurchgangsöffnung 12 angeordnet, sodass jeder der vier freien Flächenabschnitte 14 von insgesamt zweiundzwanzig Wärmedurchgangsöffnungen 12 ringsum umgeben ist.

Die Fig. 6 bis 20 zeigen weitere Anordnungsvarianten von Wärmedurchgangsöffnungen 12 auf Leiterplatten. Die Leiterplatten sowie die Anordnungen der Wärmedurchgangsöffnungen 12 werden bei den Varianten nach den Fig. 6 bis 20 nur dort beschrieben, wo sie sich von dem unterscheiden, was bereits zur Ausführung nach den Fig. 1 bis 5 diskutiert wurde.

Die Ausführung nach Fig. 6 weist rechteckige freie Flächenabschnitte 14 auf mit einer Erstreckung von 1,2 mm in x-Richtung und 8,2 mm in y-Richtung. Durch die vergrößerten freien Flächenabschnitte 14 und die daraus resultierenden vergrößerten Lotflächen resultiert eine Verbesserung der Haftung des elektronischen Bauteils 3 an der Oberseite 2 der Leiterplatte 1.

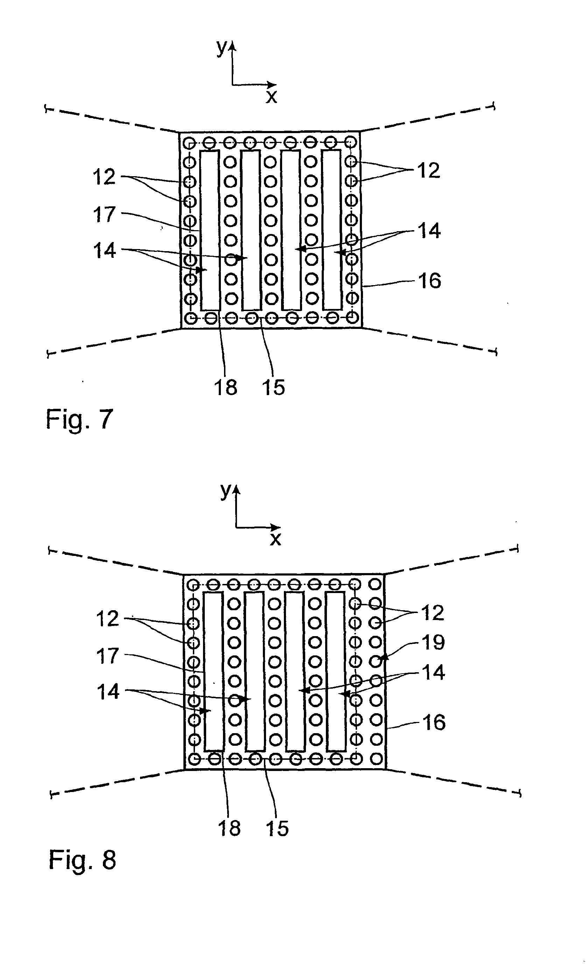

Bei der Ausführung nach Fig. 7 haben die freien Flächenabschnitte 14 Abmessungen von 0,9 mm in x-Richtung und 8,2 mm in y-Richtung. Auch hierdurch wird im Vergleich zu den freien Flächenabschnitten 14 nach Fig. 4 eine Verbesserung der Haftung des elektronischen Bauteils 3 an der Leiterplatte 1 ermöglicht. Im Vergleich zur Variante nach Fig. 6 sind die Längsseiten 17 etwas weiter von den ihnen benachbarten Wärmedurchgangsöffnungen 12 entfernt, sodass die Gefahr eines unerwünschten Eintritts von Lot in die Wärmedurchgangsöffnungen 12 verringert ist.

Bei der Ausführung nach Fig. 8 ist der Flächenbereich 16 der Leiterplatte 1 in x-Richtung um 1 mm verbreitert, sodass eine quadratische Leiterplatte 1 mit Abmessungen 10 mm x 10 mm resultiert. Ansonsten ist die Ausgestaltung hinsichtlich der relativen Anordnung der Leiterplatte 1 zum elektronischen Bauteil 3 unverändert. Es ergibt sich in Fig. 8 rechts eine weitere Spalte 19 mit insgesamt zehn Wärmedurchgangsöffnungen 12, die nicht vom elektronischen Bauteil 3 abgedeckt wird. Damit erhöht sich die Anzahl der Wärmedurchgangsöffnungen bei der Ausführung nach Fig. 8 auf insgesamt 68. Durch die zehn zusätzlichen Wärmedurchgangsöffnungen 12 verbessert sich der Wärmedurchgang durch die Leiterplatte 1.

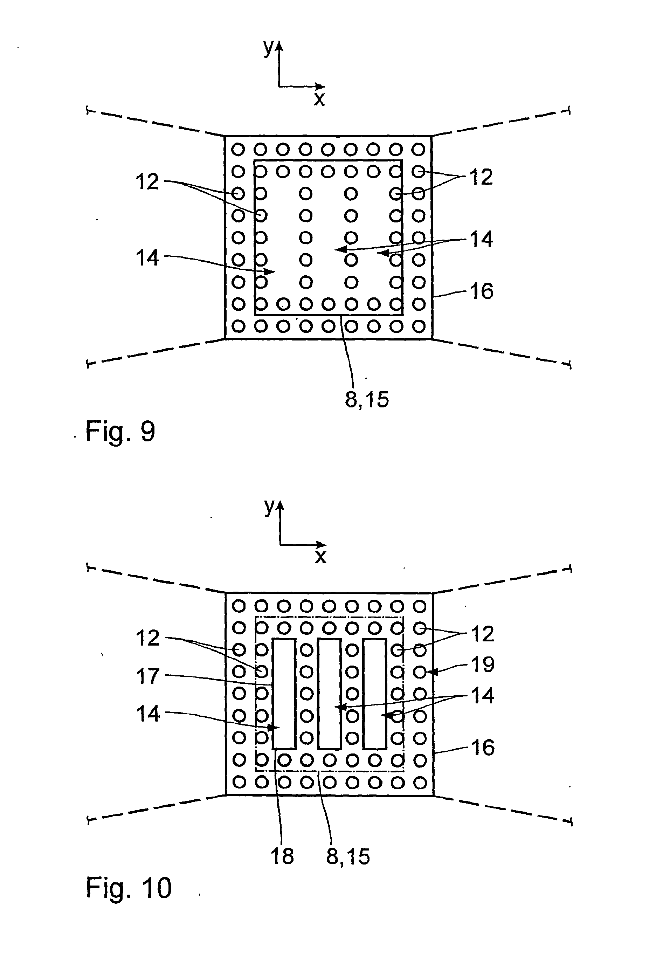

Bei der Ausführung nach Fig. 9 fallen die Abmessungen der Lotschicht 8 mit denen des Verbindungsbereichs 15 zusammen. Dort liegt also Lot auch außerhalb der freien Flächenabschnitte 14 vor. Bei der Ausführung nach Fig. 9 sind insgesamt drei freie Flächenabschnitte 14 vorgesehen. Abgesehen von den freien Flächenabschnitten 14 liegen bei der Ausführung nach Fig. 9 die Wärmedurchgangsöffnungen 12 in einem regelmäßigen, versatzfreien, also kubisch-flächenzentrierten Raster mit einer Rasterweite von 1,25 mm vor. Den Längsseiten der freien Flächenabschnitte 14 sind bei dieser Ausführungsform jeweils fünf Wärmedurchgangsöffnungen 12 benachbart. Den Schmalseiten der freien Flächenabschnitte 14 ist bei dieser Ausführung jeweils eine Wärmedurchgangsöffnung 12 benachbart. Auch den vier Ecken der freien Flächenabschnitte 14 ist bei dieser Ausführung jeweils eine Wärmedurchgangsöffnung 12 benachbart, sodass alle drei freien Flächenabschnitte 14 bei dieser Ausführung von insgesamt sechzehn Durchgangsöffnungen 12 umgeben sind. Nach außen hin schließt sich an die den freien Flächenabschnitten dieser Ausführung benachbarten Wärmedurchgangsöffnungen 12 eine quadratisch umlaufende äußere Bahn mit jeweils neun Wärmdurchgangsöffnungen pro Seite an. Insgesamt liegen bei der Ausführung nach Fig. 9 daher 66 Durchgangsöffnungen 12 vor. Der Flächenbereich 16, der mit Wärmedurchgangsöffnungen 12 versehen ist, hat bei der Leiterplatte 1 Abmessungen von 11,5 mm x 11,5 mm. Es ergibt sich bei einem elektronischen Bauteil 3 mit Verbindungsbereich-Abmessungen von 8 mm x 9 mm ein Überstand des Flächenbereichs 16 über den Verbindungsbereich 15 in x-Richtung von 1,75 mm und in y-Richtung von 1,25 mm. Die außen umlaufende Bahn von Wärmedurchgangsöffnungen 12 wird nicht vom elektronischen Bauteil 3 abgedeckt. Alle anderen Wärmedurchgangsöffnungen 12 werden vom elektronischen Bauteil 3 abgedeckt. Die Vergrößerung der zugänglichen Lotfläche führt zu einer Verbesserung der Haftung des elektronischen Bauteils 3 an der Oberseite 2 der Leiterplatte 1. Die Außenbahn von Wärmedurchgangsöffnungen 12 gleicht die Verringerung des Wärmedurchgangs durch die Erhöhung des Rastermaßes der Wärmedurchgangsöffnungen 12 im Vergleich zu den Ausführungen nach den Fig. 1 bis 8 zumindest teilweise aus.

Die Ausführung nach Fig. 10 entspricht derjenigen nach Fig.9 mit dem Unterschied, dass bei der Ausführung nach Fig. 10 die Lotschicht 8 zur Verbindung des elektronischen Bauteils 3 mit der Leiterplatte 1 nur innerhalb der freien Flächenabschnitte 14 auf der Oberseite 2 frei zugänglich ist.

Bei der Ausführung nach Fig. 10 liegen 66 Wärmedurchgangsöffnungen 12 vor. Die Reduzierung der frei zugänglichen Lotschicht 8 auf die freien Flächenabschnitte 14 verhindert, dass beim Löten Lot in die Wärmedurchgangsöffnungen 12 eindringt.

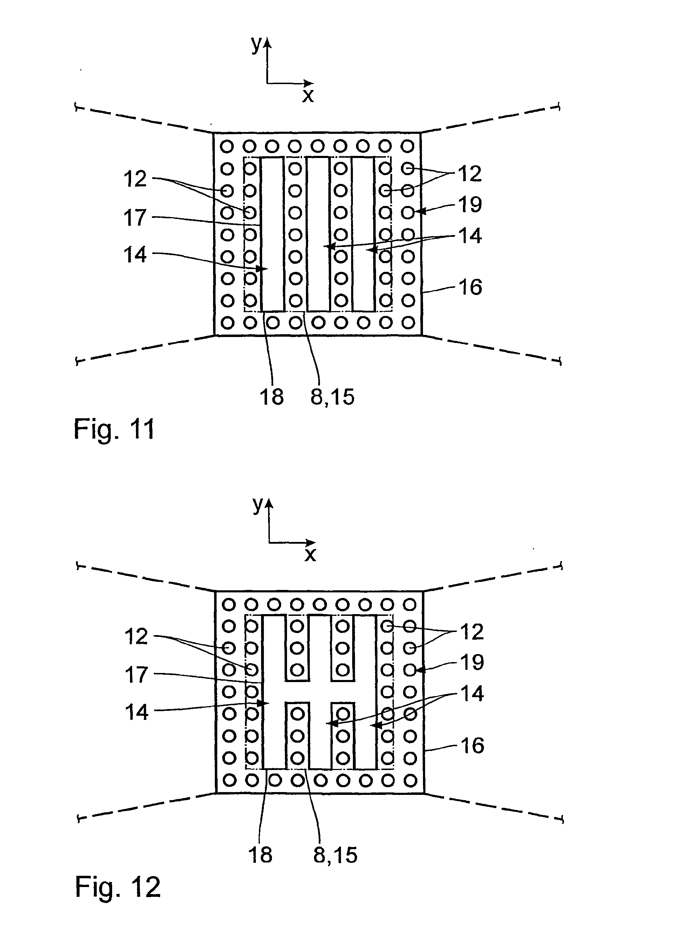

Die Ausführung nach Fig. 11 ähnelt derjenigen nach Fig. 10, sodass die Ausführung nach Fig. 11 nur dort beschrieben wird, wo sie sich von derjenigen nach Fig. 10 unterscheidet. Bei der Ausführung nach Fig. 11 sind die freien Flächenabschnitte 14 längs ihrer Längsseiten 17 derart verlängert, dass den Längsseiten 17 bei gleichem Rastermaß nunmehr sieben Wärmedurchgangsöffnungen 12 benachbart sind. Im Unterschied zur Ausführung nach Fig. 10 fallen also sechs Wärmedurchgangsöffnungen auf Kosten einer entsprechenden Vergrößerung der freien Flächenabschnitte 14 weg. Bei der Ausführung nach Fig. 11 liegen also 60 Wärmedurchgangsöffnungen 12 vor. Die im Vergleich zur Ausführung nach Fig. 10 vergrößerte Fläche der freien Flächenabschnitte 14 verbessert die Haftung des elektronischen Bauteils 3 an der Leiterplatte 1.

Die Ausführung nach Fig. 12 ähnelt derjenigen nach Fig. 11, sodass die Ausführung nach Fig. 1 nachfolgend nur dort beschrieben wird, wo sie sich von der nach Fig. 11 unterscheidet. Zwischen zwei benachbarten freien Flächenabschnitten 14 ist bei der Ausführung nach Fig. 12 jeweils die mittlere der sieben Wärmedurchgangsöffnungen 12 längs der Längsseiten 17 der freien Flächenabschnitte 14 weggelassen. Am Ort dieser Weglassung ergibt sich ein zusätzlicher freier Flächenabschnitt in Gestalt einer Zeile bei der Darstellung nach Fig. 12. Auch dort ist die Lotschicht 8 frei zugänglich, sodass die Haftung des elektronischen Bauteils 3 an der Leiterplatte 1 im Vergleich zur Ausführung nach Fig. 11 nochmals verbessert ist. Die Ausführung nach Fig. 12 hat, da im Vergleich zur Fig. 11 zwei Wärmedurchgangsöffnungen 12 weggelassen sind, insgesamt 58 Wärmedurchgangsöffnungen.

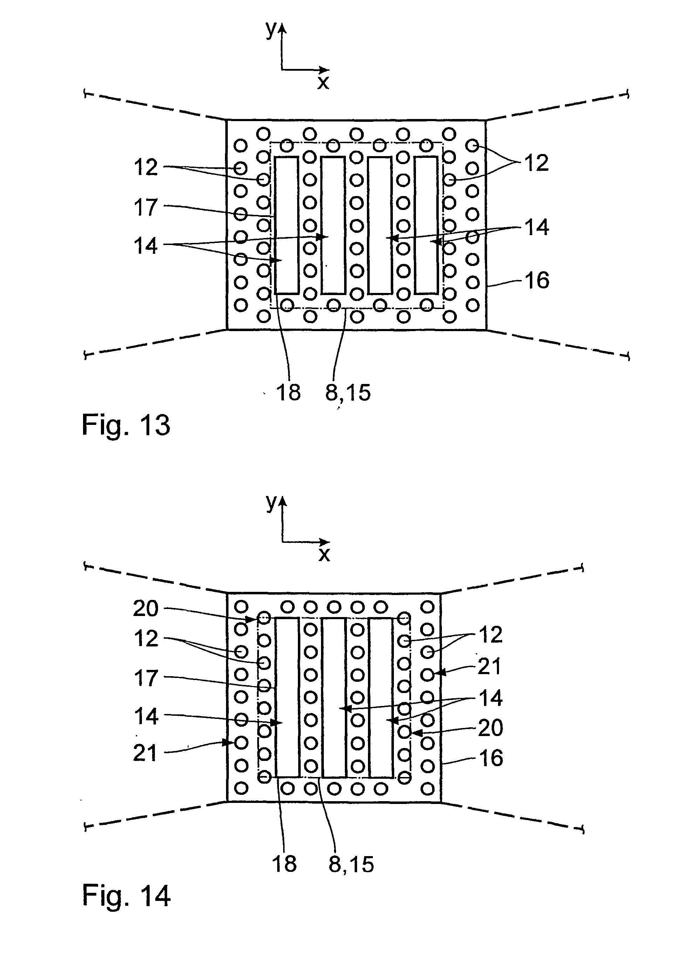

Die Ausführung nach Fig. 13 wird anhand eines Vergleichs mit der Ausführung nach Fig. 4 dort beschrieben, wo sie sich von der Ausführung nach Fig. 4 unterscheidet. Die vier freien Flächenabschnitte 14 weisen längsseitig sieben Wärmedurchgangsöffnungen 12 auf, wobei die äußeren beiden dieser sieben Wärmedurchgangsöffnungen 12 soweit außen liegen, dass sie etwas über die Längsseiten 17 überstehen. Den Schmalseiten 18 ist jeweils eine Wärmedurchgangsöffnung 12 benachbart, sodass jeder der vier freien Flächenabschnitte 14 ringsum von insgesamt sechzehn Wärmedurchgangsöffnungen 12 umgeben ist. Weitere Wärmedurchgangsöffnungen 12 sind um die drei freien Flächenabschnitte 14 nach Art einer einfach kubischen Packung mit einer Rasterweite von 1,25 mm innerhalb des Flächenbereichs 16 angeordnet. Abgesehen von den im Bereich der freien Flächenabschnitte 14 fehlenden Wärmedurchgangsöffnungen 12 liegen insgesamt elf Spalten von Wärmedurchgangsöffnungen 12 vor, wobei Spalten mit acht Wärmedurchgangsöffnungen 12, die auch randseitig vorliegen, sich mit hierzu versetzten Spalten von neun Wärmedurchgangsöffnungen 12 abwechseln. Der Flächenbereich 16 der Leiterplatte 1, der mit Wärmedurchgangsöffnungen 12 versehen ist, hat Abmessungen von 12,5 mm in x-Richtung und von 11,5 mm in y-Richtung. Ingesamt liegen 69 Wärmedurchgangsöffnungen 12 bei der Variante nach Fig. 13 vor. Aufgrund der einfach kubischen Packung liegt um die drei freien Flächenabschnitte 14 herum eine relativ große Anzahl von Wärmedurchgangsöffnungen 12 vor. In diesem Bereich kommt es daher zu einem guten Wärmedurchgang.

Die Ausführung nach Fig. 14 wird nachfolgend nur dort beschrieben, wo sie sich zu derjenigen nach Fig. 11 unterscheidet. Bei der Ausführung nach Fig. 14 liegen den Längsseiten 17 und den Schmalseiten 18 benachbart die Wärmedurchgangsöffnungen 12, was die einander zugewandten Längsseiten 17 und die Schmalseiten 18 angeht, in der gleichen Anordnung vor, wie die Wärmedurchgangsöffnungen 12 bei der Ausführung nach Fig. 11. An den beiden äußeren Längsseiten 17 der außenliegenden freien Flächenabschnitte 14 schließen sich zwei einfach kubisch gepackte Spalten 20, 21 von Wärmedurchgangsöffnungen 12 an. Die beiden inneren, den Längsseiten 17 direkt benachbarten Spalten 20 haben jeweils acht Wärmedurchgangsöffnungen 12. Die beiden äußeren Spalten 21 haben jeweils neun Wärmedurchgangsöffnungen 12. Das Rastermaß beträgt 1,25 mm. Insgesamt liegen bei der Ausführung nach Fig. 14 daher 58 Wärmedurchgangsöffnungen 12 vor. Im Bereich der Längsseiten 17 der beiden äußeren freien Flächenabschnitte 14 findet durch die dort vorliegende einfach kubische Packung der Wärmedurchgangsöffnungen 12 ein guter Wärmedurchtritt statt. Die einfach kubische Packung ermöglicht im Vergleich zur kubisch-flächenzentrierten Packung bei gegebener Fläche und Rastermaß eine größere Anzahl von Wärmedurchgangsöffnungen 12, die untergebracht werden können.

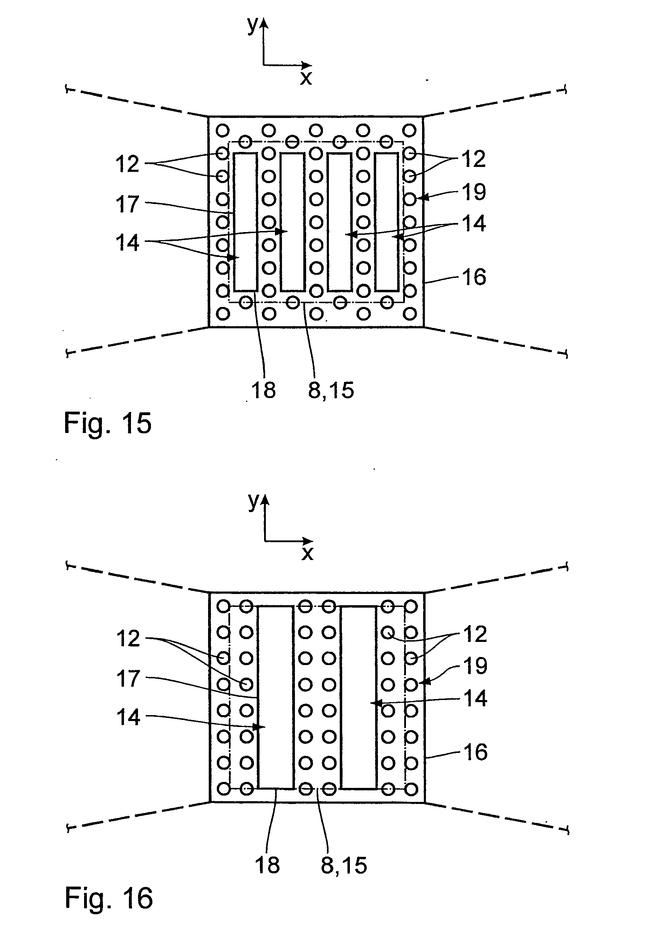

Die Ausführung nach Fig. 15 wird nur dort beschrieben, wo sie sich von derjenigen nach Fig. 13 unterscheidet. Bei der Ausführung nach Fig. 15 sind die äußere linke und die äußere rechte Spalte von Wärmedurchgangsöffnungen weggelassen. Insgesamt liegen 53 Wärmedurchgangsöffnungen 12 in einer einfach kubischen Packung vor. Der mit Wärmedurchgangsöffnungen 12 versehene Flächenbereich 16 ist reduziert auf 10,5 mm in x-Richtung und 11,5 mm in y-Richtung.

Die Ausgestaltung nach Fig. 16 hat zwei freie Flächenabschnitte 14, die in Fig. 16 spaltenweise, also längs der y-Richtung angeordnet sind. Die Lotschicht 8 ist nur im Bereich der freien Flächenabschnitte 14 auf der Oberseite 2 der Leiterplatte 1 zugänglich. Den Längsseiten 17 der freien Flächenabschnitte 14 sind jeweils acht Wärmedurchgangsöffnungen 12 benachbart zugeordnet. Zwischen den beiden freien Flächenabschnitten 14 sowie auf der jeweils gegenüberliegenden Seite der freien Flächenabschnitte 14 liegen jeweils zwei Spalten von Wärmedurchgangsöffnungen 12 kubisch-flächenzentriert mit einem Rastermaß von 1,25 mm vor. Insgesamt hat die Ausführung nach Fig. 16 also sechs Spalten zu je acht Wärmedurchgangsöffnungen 12, also insgesamt 48 Wärmedurchgangsöffnungen 12. Der Flächenbereich 16, der mit Wärmedurchgangsöffnungen 12 versehen ist, hat Abmessungen von 10,25 mm × 10,25 mm.

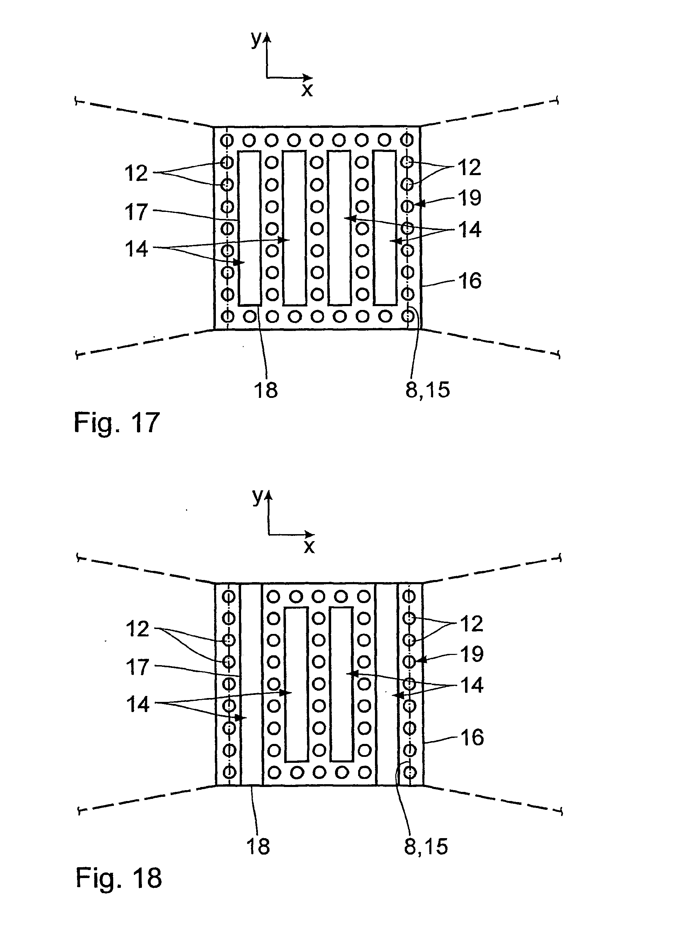

Die Ausführung nach Fig. 17 wird nachfolgend nur dort beschrieben, wo sie sich von derjenigen nach Fig. 4 unterscheidet. Den Längsseiten der freien Flächenabschnitte 14 sind bei der Ausführung nach Fig. 17 nicht acht, sondern sieben Wärmedurchgangsöffnungen 12 benachbart. Insgesamt hat die Ausführung nach Fig. 17 daher fünf Wärmedurchgangsöffnungen 12 weniger als die Ausführung nach Fig. 4, sodass insgesamt 53 Wärmedurchgangsöffnungen 12 vorliegen. Mit der Verringerung der Anzahl der Wärmedurchgangsöffnungen 12 längs der Längsseiten 17 geht eine entsprechende Verkürzung der Längsseiten 17 einher, sodass der Flächenbereich 16, der mit Wärmedurchgangsöffnungen 12 versehen ist, Abmessungen von 9 mm x 9 mm aufweist.

Die Ausführung nach Fig. 18 wird nur dort beschrieben, wo sie sich von derjenigen nach Fig. 17 unterscheidet. Die beiden äußeren freien Flächenabschnitte 14 sind bei der Ausführung nach Fig. 18 längs ihrer Längsseiten 17 derart bis zum Rand des Flächenbereichs 16 verlängert, dass die den Schmalseiten 18 benachbarten Wärmedurchgangsöffnungen 12 dort im Unterschied zur Ausführung nach Fig.17 nicht vorliegen. Insgesamt hat die Ausführung nach Fig. 18 also vier Wärmedurchgangsöffnungen 12 weniger als die Ausführung nach Fig. 17, sodass insgesamt 49 Wärmedurchgangsöffnungen 12 resultieren. Aufgrund der hierdurch vergrößerten äußeren beiden freien Flächenabschnitte 14 ist die Haftung des elektronischen Bauteils 3 an der Leiterplatte 1 verbessert.

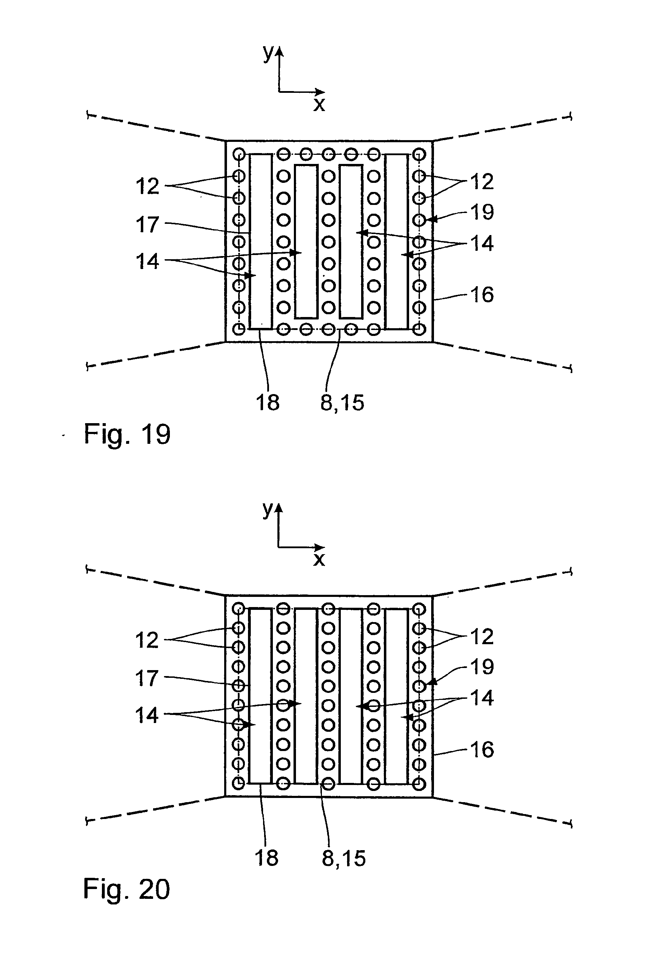

Die Ausführung nach Fig. 19 wird nachfolgend nur dort beschrieben, wo sie sich von derjenigen nach Fig. 4 unterscheidet. Ähnlich wie bei der Ausführung nach Fig. 18 sind auch bei der Ausführung nach Fig. 19 die den Schmalseiten der beiden äußeren freien Flächenabschnitte 14 benachbarten Wärmedurchgangsöffnungen 12 weggelassen und diese beiden äußeren freien Flächenabschnitte 14 sind bis zum Rand des Verbindungsbereiches 15 gezogen. Im Vergleich zur Ausführung nach Fig. 4 fehlen also bei der Ausführung nach Fig. 19 vier Wärmedurchgangsöffnungen, sodass insgesamt 54 Wärmedurchgangsöffnungen 12 vorliegen.

Die Ausführung nach Fig. 20 wird nur dort beschrieben, wo sie sich von derjenigen nach Fig. 19 unterscheidet. Bei der Ausführung nach Fig. 20 sind auch die den Schmalseiten der beiden inneren freien Flächenabschnitte 14 benachbarten Wärmedurchgangsöffnungen 12 weggelassen und diese beiden inneren freien Flächenabschnitte 14 sind bis an den Rand des Verbindungsbereichs 15 gezogen. Es liegen somit fünf Spalten von Wärmedurchgangsöffnungen 12 zu je zehn Wärmedurchgangsöffnungen 12 vor, wobei jeweils zwischen zwei benachbarten dieser Spalten ein freier Flächenabschnitt 14 liegt.

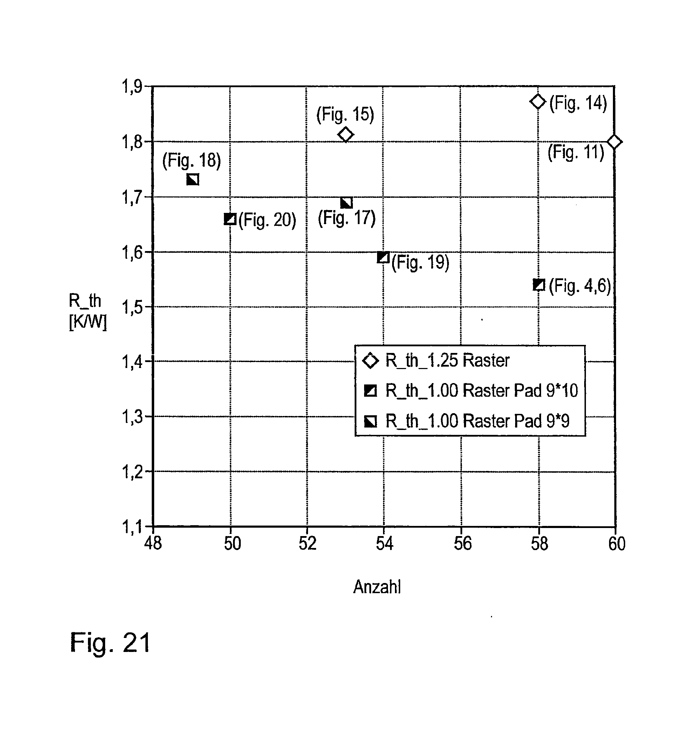

Das Diagramm nach Fig. 21 verdeutlicht den Einfluss verschiedener Parameter auf den Wärmeübergang durch die Leiterplatte 1. Aufgetragen ist der thermische Widerstand Rₜₕ in Abhängigkeit von der Anzahl der Wärmedurchgangsöffnungen 12. Die Quadrate geben den thermischen Widerstand für Anordnungen mit der Rasterweite 1,0 mm an.

Das Quadrat zur Anzahl 49 entspricht der Anordnung nach Fig. 18. Dort liegt ein Thermischer Widerstand von etwa 1,73 K/W vor. Dieser Wert ergibt sich aus einer Modellberechnung, in die neben der Geometrie der Anordnung auch die Wärmeleitfähigkeiten, die Wärmekapazitäten und die Dichten der verschiedenen beteiligten Materialien eingehen.

Das Quadrat bei der Anzahl 50 entspricht der Anordnung nach Fig. 20. Dort ist im Vergleich zur Anordnung nach Fig. 18 der thermische Widerstand auf etwa 1,66 K/W verringert. Dies liegt neben der Vergrößerung der Anzahl der Wärmedurchgangsöffnungen 12 auch daran, dass der Flächenbereich 16 bei der Ausführung nach Fig. 20 gegenüber der Ausführung nach Fig. 18 vergrößert ist. Damit ist eine größere Wärmeübergangsfläche geschaffen, was den thermischen Widerstand verringert.

Das Quadrat zur Anzahl 53 entspricht der Anordnung nach Fig. 17. Bei dieser Anordnung liegt ein thermischer Widerstand von etwa 1,69 K/W vor. Im Vergleich zur Anordnung nach Fig. 20 konkurrieren hier zwei Effekte: Zum einen ist bei der Anordnung nach Fig. 17 der Flächenbereich 16 kleiner als bei der Anordnung nach Fig. 20, was den thermischen Widerstand erhöht. Zum anderen hat die Anordnung nach Fig. 17 drei Wärmedurchgangsöffnungen 12 mehr, was den thermischen Widerstand verringert.

Das Quadrat bei der Anzahl 54 steht für die Anordnung nach Fig. 19. Hier liegt ein thermischer Widerstand von etwa 1,59 K/W vor. Im Vergleich zur Anordnung nach Fig. 20 sind hier vier zusätzliche Wärmedurchgangsöffnungen 12 vorhanden, sodass ein entsprechend niedriger thermischer Widerstand resultiert.

Das Quadrat bei der Anzahl 58 entspricht der Anordnung nach den Fig. 4 bzw. 6. Hier sind im Vergleich zur Anordnung nach Fig. 19 vier weitere Wärmedurchgangsöffnungen 12 vorhanden, sodass sich der thermische Widerstand weiter auf etwa 1,54 K/W verringert.

Die Raute bei der Anzahl 53 entspricht der Anordnung nach Fig. 15. Hier liegt ein größeres Rastermaß der Wärmedurchgangsöffnungen 12 vor, sodass ein im Vergleich zur Anordnung nach Fig. 17 mit der gleichen Anzahl von Wärmedurchgangsöffnungen 12 größerer thermischer Widerstand von etwa 1,81 K/W resultiert.

Die Raute zur Anzahl 58 entspricht der Anordnung nach Fig. 14. Hier liegen zwei Spalten von Wärmedurchgangsöffnungen 12, nämlich die beiden Spalten 21, vor, die relativ weit vom Verbindungsbereich 15, in dem das elektronische Bauteil 3 auf der Leiterplatte 1 aufliegt, entfernt sind. Dies erklärt den relativ hohen thermischen Widerstand von etwa 1,87 K/W bei der Ausführung nach Fig. 14.

Die Raute zur Anzahl 60 entspricht der Anordnung nach Fig. 11. Aufgrund der hohen Anzahl von Wärmedurchgangsöffnungen 12 ergibt sich hier eine Reduzierung des thermischen Widerstandes auf etwa 1,8 K/W.

Unter Berücksichtigung der Parameter
- Gesamtfläche der zugänglichen Lotschicht 8, die zur Optimierung der Haftung des elektronischen Bauteils 3 an der Leiterplatte 1 möglichst groß sein sollte,
- Größe des Flächenbereichs 16, der zur Realisierung einer möglichst kompakten Leiterplatte 1 nicht zu groß sein sollte,
- Anzahl der Wärmedurchgangsöffnungen 12, die zur Realisierung eines guten Wärmedurchgangs groß, aber aus Gründen der Herstellungskosten und -möglichkeiten nicht zu groß sein sollte,
stellt sich die Ausführung nach Fig. 4 als nach derzeitigem Stand besonders geeignet heraus.

## Patentansprüche

1. Leiterplatte (1)
- mit einer Oberseite (2) zur Anlage eines elektronischen Bauteils (3)
- mit einer Unterseite (4) zur Auflage auf eine wärmeabführende Unterlage (5),
- mit einer Mehrzahl von Wärmedurchgangsöffnungen (12), die einen Wärmedurchgang von der Oberseite (2) zur Unterseite (4) schaffen,
- wobei die Wärmedurchgangsöffnungen (12) auf der Oberseite (2) derart ungleich verteilt vorliegen, dass die Oberseite (2) mehrere freie Flächenabschnitte (14) aufweist, die zur Verbindung des elektronischen Bauteils (3) mit der Leiterplatte (1) frei von Wärmedurchgangsöffnungen (12) sind,
**dadurch gekennzeichnet, dass** die freien Flächenabschnitte (14) spalten- bzw. zeilenweise angeordnet sind, wobei zumindest längs der langen Seiten (17) der freien Flächenabschnitte (14) jeweils eine Mehrzahl von Wärmedurchgangsöffnungen (12) angeordnet ist.

2. Leiterplatte nach Anspruch 1, **dadurch gekennzeichnet, dass** mindestens drei, vorzugsweise vier freie Flächenabschnitte (14) vorgesehen sind.

3. Leiterplatte nach Anspruch 1 oder 2, **dadurch gekennzeichnet, dass** mindestens zwei der freien Flächenabschnitte (14) ringsum von Wärmedurchgangsöffnungen (12) umgeben sind.

4. Leiterplatte nach Anspruch 3, **dadurch gekennzeichnet, dass** alle freien Flächenabschnitte (14) ringsum von Wärmedurchgangsöffnungen (12) umgeben sind.

5. Leiterplatte nach einem der Ansprüche 1 bis 4, **dadurch gekennzeichnet, dass** in einem Abschnitt (16) der Leiterplatte (1) mit Flächenabmessungen etwa 10 mm x 10 mm etwa fünfzig Wärmedurchgangsöffnungen (12) vorgesehen sind.

6. Leiterplatte nach einem der Ansprüche 1 bis 5, **dadurch gekennzeichnet, dass** die Wärmedurchgangsöffnungen (12) ausschließlich dort (15) auf der Oberseite (2) der Leiterplatte (1) vorgesehen sind, wo sie bei aufgelegtem elektronischen Bauteil (3) von diesem zumindest teilweise abgedeckt werden.

7. Leiterplatte nach einem der Ansprüche 1 bis 6, **dadurch gekennzeichnet, dass** der Flächenbereich (16) der Oberseite (2) der Leiterplatte (1), der mit den Wärmedurchgangsöffnungen (12) versehen ist, geometrisch angepasst ist an die Geometrie der Anlagefläche des elektronischen Bauteils (3) an die Oberseite (2) der Leiterplatte (1).

8. Leiterplatte nach einem der Ansprüche 1 bis 7, **dadurch gekennzeichnet, dass** abgesehen von den freien Flächenabschnitten (14), die Wärmedurchgangsöffnungen (12) in einem regelmäßigen Raster mit einer Rasterweite von höchstens 1,5 mm, vorzugsweise höchstens 1,25 mm, mehr bevorzugt höchstens 1,0 mm, angeordnet sind.

9. Leiterplatte nach Anspruch 8, **dadurch gekennzeichnet, dass** das Raster der Wärmedurchgangsöffnungen (12) eine einfach kubische Packung aufweist.

10. Leiterplatte nach einem der Ansprüche 1 bis 9, **gekennzeichnet durch** eine auf die Oberseite (2) insbesondere abschnittsweise aufgebrachte Lotschicht (8) zur Verbindung des elektronischen Bauteils (3) mit der Leiterplatte (1), wobei die Lotschicht (8) nur innerhalb der freien Flächenabschnitte (14) auf der Oberseite (2) frei zugänglich ist und vorzugsweise nur innerhalb der freien Flächenabschnitte (14) auf der Leiterplatte (1) aufgebracht ist.

11. Leiterplatte nach Anspruch 10, **dadurch gekennzeichnet, dass** die Lotschicht (8) innerhalb der freien Flächenabschnitte (14) rechteckig mit Abmessungen von etwa 1 mm x 10 mm ist.

12. Leiterplatte nach einem der Ansprüche 1 bis 11, **dadurch gekennzeichnet, dass** die Wärmedurchgangsöffnungen (12) eine Weite zwischen 0,3 mm und 0,5 mm haben.

13. Leiterplatte nach einem der Ansprüche 1 bis 12, **dadurch gekennzeichnet, dass** jede Wärmedurchgangsöffnung (12) innenseitig eine wärmeleitende Beschichtung trägt, insbesondere eine Metallbeschichtung, bevorzugt mit einer Schichtdicke im Bereich von 30 µm.

14. Leiterplatte nach einem der Ansprüche 1 bis 13, **dadurch gekennzeichnet, dass** die Wärmedurchgangsöffnungen (12) frei, also ungefüllt, vorliegen.

## Claims

1. A printed circuit board (1)
- with an upper side (2) for attaching an electronic component (3)
- with a lower side (4) for applying a heat removing underlay (5)
- with a plurality of heat transition openings (12) which create heat transition from the upper side (2) to the lower side (4)
- wherein the heat transition openings (12) are distributed on the upper side (2) in an uneven manner, such that the upper side (2) comprises several free surface sections (14) which in order to connect the electronic component (3) with the printed circuit board (1) are free of heat transition openings (12),
**characterized in that** the free surface sections (14) are arranged in columns or rows, wherein at least along the long sides (17) of the free surface sections (14), a plurality of heat transition openings (12) is arranged respectively.

2. A printed circuit board according to claim 1, **characterized in that** at least three, preferably four free surface sections (14) are provided.

3. A printed circuit board according to either of claims 1 or 2, **characterized in that** at least two of the free surface sections (14) are surrounded on all sides by heat transition openings (12).

4. A printed circuit board according to claim 3, **characterized in that** all free surface sections (14) are surrounded on all sides by heat transition openings (12).

5. A printed circuit board according to any one of claims 1 to 4, **characterized in that** in one section (16) of the printed circuit board (1), approximately fifty heat transition openings (12) are provided with surface dimensions of approximately 10mm x 10mm.

6. A printed circuit board according to any one of claims 1 to 5, **characterized in that** the heat transition openings (12) are provided only at those points (15) on the upper side (2) of the printed circuit board (1) where they are at least partially covered when the electronic component (3) is laid on.

7. A printed circuit board according to any one of claims 1 to 6, **characterized in that** the surface area (16) of the upper side (2) of the printed circuit board (1) which is provided with the heat transition openings (12) is geometrically adapted to the geometry of the contact surface of the electronic component (3) on the upper side (2) of the printed circuit board (1).

8. A printed circuit board according to any one of claims 1 to 7, **characterized in that** aside from the free surface sections (14), the heat transition openings (12) are arranged in a regular grid with a grid width of maximum 1.5mm, preferably maximum 1.25mm, even more preferred, maximum 1.0mm.

9. A printed circuit board according to claim 8, **characterized in that** the grid of the heat transition openings (12) comprises a simple, cuboid packing.

10. A printed circuit board according to any one of claims 1 to 9, **characterized by** a solder layer (8) which is applied to the upper side (2) in particular in sections, for connecting the electronic component (3) with the printed circuit board (1), wherein the solder layer (8) is only freely accessible within the free surface sections (14) on the upper side (2), and is preferably only applied within the free surface sections (14) on the printed circuit board (1).

11. A printed circuit board according to claim 10, **characterized in that** the solder layer (8) within the free surface sections (14) is rectangular with dimensions of approximately 1mm x 10mm.

12. A printed circuit board according to any one of claims 1 to 11, **characterized in that** the heat transition openings (12) have a width of between 0.3 and 0.5mm.

13. A printed circuit board according to any one of claims 1 to 12, **characterized in that** each heat transition opening (12) bears on its inner side a heat conducting layer, in particular a metal layer, preferably with a layer thickness in the range of 30µm.

14. A printed circuit board according to any one of claims 1 to 13, **characterized in that** the heat transition openings (12) are free, i.e. unfilled.

## Revendications

1. Plaquette de circuit imprimé (1)
- avec un côté supérieur (2) destiné à supporter un composant électronique (3)
- avec un côté inférieur (4) destiné à être posé sur un substrat (5) évacuant la chaleur,
- avec une multiplicité d'ouvertures de passage de chaleur (12) qui réalisent un passage de chaleur depuis le côté supérieur (2) vers le côté inférieur (4),
- les ouvertures de passage de chaleur (12) étant placées sur le côté supérieur (2) réparties de façon irrégulière de telle sorte que le côté supérieur (2) présente plusieurs tronçons de surface (14) libres qui sont exempts d'ouvertures de passage de chaleur (12) pour le raccordement du composant électronique (3) à la plaquette de circuit imprimé (1),
**caractérisée en ce que** les tronçons de surface (14) libres sont disposés en colonnes ou en lignes, une multiplicité d'ouvertures de passage de chaleur (12) étant disposées respectivement au moins le long des grands côtés (17) des tronçons de surface (14) libres.

2. Plaquette de circuit imprimé selon la revendication 1, **caractérisée en ce qu'**au moins trois, de préférence quatre tronçons de surface (14) libres, sont prévus.

3. Plaquette de circuit imprimé selon la revendication 1 ou 2, **caractérisée en ce qu'**au moins deux des tronçons de surface (14) libres sont entourés sur tout leur pourtour d'ouvertures de passage de chaleur (12).

4. Plaquette de circuit imprimé selon la revendication 3, **caractérisée en ce que** tous les tronçons de surface (14) libres sont entourés sur tout leur pourtour d'ouvertures de passage de chaleur (12).

5. Plaquette de circuit imprimé selon une des revendications 1 à 4, **caractérisée en ce que**, dans un tronçon (16) de la plaquette de circuit imprimé (1) ayant des dimensions de surface d'environ 10 mm x 10 mm, il est prévu environ cinquante ouvertures de passage de chaleur (12).

6. Plaquette de circuit imprimé selon une des revendications 1 à 5, **caractérisée en ce que** les ouvertures de passage de chaleur (12) sont prévues sur le côté supérieur (2) de la plaquette de circuit imprimé (1) exclusivement là (15) où elles sont recouvertes au moins partiellement par le composant électronique (3) quand celui-ci est placé dessus.

7. Plaquette de circuit imprimé selon une des revendications 1 à 6, **caractérisée en ce que** la zone superficielle (16) du côté supérieur (2) de la plaquette de circuit imprimé (1) qui est munie des ouvertures de passage de chaleur (12) est géométriquement adaptée à la géométrie de la face d'appui du composant électronique (3) sur le côté supérieur (2) de la plaquette de circuit imprimé (1).

8. Plaquette de circuit imprimé selon une des revendications 1 à 7, **caractérisée en ce que**, à l'exception des tronçons de surface (14) libres, les ouvertures de passage de chaleur (12) sont disposées selon une trame régulière ayant une largeur de trame de 1,5 mm maximum, de préférence de 1,25 mm maximum, de façon encore plus préférée de 1,0 mm maximum.

9. Plaquette de circuit imprimé selon la revendication 8, **caractérisée en ce que** la trame des ouvertures de passage de chaleur (12) présente une structure simplement cubique.

10. Plaquette de circuit imprimé selon une des revendications 1 à 9, **caractérisée par** une couche de brasure (8) appliquée en particulier par tronçons sur le côté supérieur (2) pour le raccordement du composant électronique (3) à la plaquette de circuit imprimé (1), la couche de brasure (8) n'étant librement accessible qu'à l'intérieur des tronçons de surface (14) libres sur le côté supérieur (2), et n'étant de préférence appliquée qu'à l'intérieur des tronçons de surface (14) libres sur la plaquette de circuit imprimé (1).

11. Plaquette de circuit imprimé selon la revendication 10, **caractérisée en ce que** la couche de brasure (8) à l'intérieur des tronçons de surface (14) libres est rectangulaire avec des dimensions d'environ 1 mm x 10 mm.

12. Plaquette de circuit imprimé selon une des revendications 1 à 11, **caractérisée en ce que** les ouvertures de passage de chaleur (12) ont une largeur entre 0,3 mm et 0,5 mm.

13. Plaquette de circuit imprimé selon une des revendications 1 à 12, **caractérisée en ce que** chaque ouverture de passage de chaleur (12) porte intérieurement un revêtement conduisant la chaleur, en particulier un revêtement métallique, de préférence avec une épaisseur de couche dans la plage de 30 µm.

14. Plaquette de circuit imprimé selon une des revendications 1 à 13, **caractérisée en ce que** les ouvertures de passage de chaleur (12) sont présentes sous une forme libre, donc non remplie.
